# EUROPEAN PATENT APPLICATION

(11) **EP 3 698 964 A1**
(43) Date of publication of application: **26.08.2020**
(21) Application number: 18869349.3
(22) Date of filing: 10.10.2018
(51) Int. Cl.: B32B 27/00, B32B 27/36, H01L 51/50, H05B 33/02, H05B 33/04

(54) **BASE MATERIAL FOR GAS-BARRIER FILMS, GAS-BARRIER FILM, MEMBER FOR ELECTRONIC DEVICES, AND ELECTRONIC DEVICE**

(30) Priority: 20.10.2017 JP 2017203236; 27.03.2018 JP 2018059581
(71) Applicant: LINTEC Corporation, Tokyo 173-0001 (JP)
(72) Inventor: OHASHI, Takehiro, Tokyo 173-0001 (JP); IZUMI, Tatsuya, Tokyo 173-0001 (JP)
(74) Representative: Adam, Holger
(86) International application number: PCT/JP2018/037817
(87) International publication number: WO 2019/078069

(57) **Abstract**

The present invention provides :a base material for gas-barrier films comprising a resin film and a hard coat layer directly or via another layer over each of both faces of the resin film, wherein the resin film is one that has a thermal shrinkage percentage of 0.3% or less, when measured after heating the resin film under a condition of 150°C for 2 hours in conformity with JIS K7133, and glass-transition temperature (Tg) of a resin constituting the resin film is 100°C or lower; a gas-barrier film comprising, directly or via another layer, a gas-barrier layer on at least one face side of the base material for gas-barrier films; a member for electronic devices including this gas-barrier film; and an electronic device provided with this member for electronic devices. According to the present invention, there are provided a base material for gas-barrier films that is unlikely to show thermal shrinkage, excellent in transparency before and after heating and inexpensive; a gas-barrier film with a gas-barrier layer formed on at least one face side of this base material; a member for electronic devices including this gas-barrier film; and an electronic device provided with this member for electronic devices.

## Description

### Technical Field

The present invention relates to a base material for gas-barrier films, a gas-barrier film with a gas-barrier layer formed on at least one face side of this base material for gas-barrier films, a member for electronic devices including this gas-barrier film, and an electronic device provided with this member for electronic devices.

### Background Art

Recently, in order to realize thinner thickness, lightened weight, flexibilization and the like of displays such as liquid crystal displays and electroluminescence (EL) displays, a resin film having gas-barrier properties (hereinafter, also referred to as "a gas-barrier film") is used as a substrate having an electrode, in place of a glass plate.

For example, in Patent Literature 1, there are described a gas-barrier film having a base material layer containing a resin having a glass-transition temperature (Tg) of higher than 130°C and a specific gas-barrier layer, a member for electronic devices including this gas-barrier film, and the like.

In Patent Literature 1, there is also described that the gas-barrier film described in this Literature is excellent in heat-resistance properties because it has the base material layer containing a resin having a glass-transition temperature (Tg) of higher than 130°C.

In a case where a gas-barrier film is to be produced industrially, a role-to-role system is usually employed.

For example, in Patent Literature 2, a gas-barrier laminated body is described, which has a primer layer and gas-barrier layer on at least one side of a base material and has a coefficient of static friction lying in a specific range when the gas-barrier laminated body is piled up so that different outermost layers are to face each other.

In this Literature, there are also described that, as a consequence of setting a coefficient of static friction in a specific range, blocking (that respective films are stuck firmly) or air entrainment (that a wrinkle is made) etc. are unlikely to occur when the laminated body is wound into a roll or is fed out from a roll to improve workability (hereinafter, may also be referred to as "windability").

However, there was such a case that a gas-barrier laminated body excellent in gas-barrier properties could not be obtained when the surface of a gas-barrier layer was made rough in a gas-barrier laminated body in which one of outermost layers was a gas-barrier layer. On the other hand, there was such a case that, when the surface of the other outermost layer was made rough, gas-barrier properties of a gas-barrier laminated body deteriorated because the surface of the gas-barrier layer was damaged as a consequence of contact of the outermost layer with the gas-barrier layer being one outermost layer in winding or feeding.

Moreover, in Patent Literature 3 a method for producing an organic electronics element excellent in performance stability by a role-to-role system excellent in productivity is described. There are described that, as a consequence of precipitation of an oligomer component present in a small amount in a base material film when heating is performed in a production process of an organic electronics element, light transmittance of an organic electronics element to be obtained may deteriorate or performance of the organic electronics element may be affected adversely due to the contamination of the oligomer component, and that, in order to prevent this, preferably both faces of a flexible transparent base material are to be coated with a clear hard coat layer.

However, in this Literature, there are no description on windability when a gas-barrier film is to be produced by a role-to-role system, or on results of performance evaluation for the gas-barrier film in winding and feeding.

### Citation List

### Patent Literature

PTL 1: WO2012/039355 (US 2013/0244044 A1)
PTL 2: WO2013/147090 (US 2015/0099094 A1)
PTL 3: WO2010/090087

### Summary of Invention

### Technical Problem

As described above, the gas-barrier film described in Patent Literature 1 is excellent in heat-resistance properties. Consequently, in a case where various functional layers are to be formed sequentially over the gas-barrier film to produce an electronic device, for example, a heat treatment of 150°C for 2 hours can be performed to produce an intended electronic device.

However, a resin film for use as a production material of the base material layer described in Patent Literature 1 is comparatively expensive and, therefore, the low cost production of a gas-barrier film excellent in heat-resistance properties is difficult.

The present invention has been made in consideration of above actual conditions, and aims at providing a base material for gas-barrier films that is unlikely to show thermal shrinkage, excellent in transparency before and after heating and is inexpensive; a gas-barrier film with a gas-barrier layer formed on at least one face side of this base material; a member for electronic devices including this gas-barrier film; and an electronic device provided with this member for electronic devices.

Moreover, the present applicant has previously proposed a gas-barrier film constituted of a resin film that is composed of a resin with a glass-transition temperature of 100°C or lower and had a thermal shrinkage percentage of 0.3% or less when measured in conformity with JIS K7133 after heating at 150°C for 2 hours, and a hard coat layer formed on both faces of the resin film and, additionally, a gas-barrier layer formed directly on one face side of the hard coat layer, in Japanese Patent Application No. 2017-203236.

In Japanese Patent Application No. 2017-203236, there have also been described that a gas-barrier film having excellent gas-barrier properties becomes easily obtainable by setting the maximum cross section height (Rt) of a roughness curve of the surface of the hard coat layer contacting the gas-barrier layer to be 150 nm or less in a gas-barrier film to be obtained, and that the gas-barrier film to be obtained is excellent in thermal shrinkage properties and transparency (a thermal shrinkage percentage is small and an amount of change in haze is small before and after heating).

However, in Japanese Patent Application No. 2017-203236, windability when a gas-barrier film is to be produced by a role-to-role system, and evaluation results of physical properties of the gas-barrier film in winding or feeding (for example, gas-barrier properties of the gas-barrier film due to contact between the face of a hard coat layer (one outermost layer) on which the gas-barrier layer is not laminated and the face of the gas-barrier layer (the other outermost layer) are not examined.

Hence, the present invention aims at providing a long-sized base material for gas-barrier films capable of giving a gas-barrier film that is excellent in thermal shrinkage properties and transparency and is excellent in operability of work upon winding into a roll shape and feeding from a roll, and that is unlikely to show deterioration in gas-barrier properties before and after the work; a long-sized gas-barrier film with a gas-barrier layer formed on at least a specific face side of this base material for gas-barrier films; a member for electronic devices including a gas-barrier film obtained using this gas-barrier film; and an electronic device provided with this member for electronic devices.

### Solution to Problem

The present inventors studied intensively about various kinds of resin films in order to solve above-described problems. As the result, we have found that a resin film made from a resin with a not so high glass-transition temperature (hereinafter, may also be described as "a resin film (α)") is available at a comparatively low price, and that, even for composite films using this, for example, those that are obtained by giving an annealing treatment to the resin film (α) or by laminating a hard coat layer on the resin film (α) may have sufficient heat-resistance properties.

Moreover, we have found that, in a long-sized base material for gas-barrier films having a resin film and each of hard coat layers [hard coat layer (I), hard coat layer (II)] over both faces thereof, a base material for gas-barrier films excellent in thermal shrinkage properties and transparency and excellent in operability of work upon winding into a roll shape and feeding from a roll is obtained, by using one, as the resin film, constituted of a resin whose glass-transition temperature (Tg) is 100°C or lower and thermal shrinkage percentage is 0.3% or less when measured after heating at 150°C for 2 hours, and setting the maximum cross section height (Rt) of roughness curves of surfaces of hard coat layers (I) and (II) so as to lie in a specific range; and that a long-sized gas-barrier film that is excellent in thermal shrinkage properties and transparency, is excellent in operability of work upon winding into a roll shape and feeding from a roll and is unlikely to show deterioration in gas-barrier properties before and after this work, is obtained by forming a gas-barrier layer on at least a specific face side of this base material for gas-barrier films.

Then, on the basis of these knowledge, the present invention has been completed.

Thus, according to the present invention, following (1) to (11) base materials for gas-barrier films, (12) to (15) gas-barrier films, (16) a member for electronic devices, and (17), (18) electronic devices are provided.
(1) A base material for gas-barrier films having a resin film and a hard coat layer directly or via another layer over each of both faces of the resin film, wherein:
   the resin film is one that has a thermal shrinkage percentage of 0.3% or less, when measured after heating the resin film under a condition of 150°C for 2 hours in conformity with JIS K7133; and
   glass-transition temperature (Tg) of a resin constituting the resin film is 100°C or lower.
(2) The base material for gas-barrier films according to (1), wherein the resin film is a polyester film having been subjected to an annealing treatment.
(3) The base material for gas-barrier films according to (1) or (2), wherein each of the hard coat layers is one obtained by curing an energy-curable resin.
(4) The base material for gas-barrier films according to any of (1) to (3), wherein each thickness of the hard coat layers is 1.0 - 10 µm.
(5) The base material for gas-barrier films according to any of (1) to (4), wherein at least one of the hard coat layers is a layer whose maximum cross section height (Rt) of a roughness curve of a surface is 150 nm or less.
(6) The base material for gas-barrier films according to any of (1) to (5), wherein the maximum cross section height (Rt) of a roughness curve of a surface of one hard coat layer [hard coat (I)] is 150 nm or less, and the maximum cross section height (Rt) of a roughness curve of a surface of the other hard coat layer [hard coat (II)] is not less than 150 nm and not more than 400 nm.
(7) The base material for gas-barrier films according to any of (1) to (6), which is a long-sized base material.
(8) The base material for gas-barrier films according to (6) or (7), wherein the hard coat layer (II) contains fine particles whose average particle diameter is not less than 1.0 µm and not more than 10 µm.
(9) The base material for gas-barrier films according to (8), wherein the fine particle is at least one kind of organic fine particle selected from the group consisting of silicone resin fine particles, acrylic resin fine particles, polystyrene resin fine particles, and styrene-acrylic copolymer resin fine particles.
(10) The base material for gas-barrier films according to (8) or (9), wherein thickness L of the hard coat layer (II) satisfies 1.0 µm ≤ L < 10 µm and L < D, when an average particle diameter of the fine particle is denoted by D µm (when two or more kinds of fine particles are contained, it means an average particle diameter of a fine particle whose average particle diameter is the largest).
(11) The base material for gas-barrier films according to any of (1) to (10), wherein haze is 2.0% or less.
(12) A gas-barrier film constituted of, directly or via another layer, a gas-barrier layer on at least one face side of the base material for gas-barrier films according to any of (1) to (11).
(13) A gas-barrier film constituted of directly a gas-barrier layer on at least one face side of the base material for gas-barrier films according to any of (1) to (11), wherein a hard coat layer contacting the gas-barrier layer is a layer whose maximum cross section height (Rt) of a roughness curve of a surface is 150 nm or less.
(14) The gas-barrier film according to claim 12 or 13, constituted of a gas-barrier layer that is formed directly on at least the hard coat layer (I) face side of the base material for gas-barrier films according to any of (1) to (11).
(15) The gas-barrier film according to any of (12) to (14), wherein the gas-barrier layer is formed by using a material containing a polysilazane-based compound.
(16) A member for electronic devices including the gas-barrier film according to any of (12) to (15).
(17) An electronic device provided with the member for electronic devices according to (16).
(18) An electronic device constituted by using, as a substrate, the member for electronic devices according to (16).

### Advantageous Effects of Invention

According to the present invention, there are provided a base material for gas-barrier films that is unlikely to show thermal shrinkage, excellent in transparency before and after heating and inexpensive; a gas-barrier film with a gas-barrier layer formed on at least one face side of this base material; a member for electronic devices including this gas-barrier film; and an electronic device provided with this member for electronic devices.

A long-sized base material for gas-barrier films of the present invention is excellent in thermal shrinkage properties and transparency, and is excellent in operability of work upon winding into a roll shape and feeding from a roll.

A long-sized gas-barrier film of the present invention is excellent in thermal shrinkage properties and transparency and excellent in operability of work upon winding into a roll shape and feeding from a roll, and is unlikely to show deterioration in gas-barrier properties before and after this work.

The member for electronic devices of the present invention includes a gas-barrier film obtained by using a long-sized gas-barrier film excellent in thermal shrinkage properties and transparency and excellent in operability of work upon winding into a roll shape and feeding from a roll, and is also excellent in productivity.

Moreover, the electronic device of the present invention is constituted by using, as a substrate, the member for electronic devices of the present invention and, therefore, is excellent in productivity and maintains stable performance over a long period.

### Description of Embodiments

Hereinafter, the present invention will be described in detail after dividing it into three heads: 1) base material for gas-barrier films, 2) gas-barrier film, and 3) member for electronic devices and electronic device.

### 1) Base material for gas-barrier films

The base material for gas-barrier films of the present invention is a base material for gas-barrier films having a resin film and hard coat layers each of which lies directly or via another layer over both faces thereof, in which the resin film is one having a thermal shrinkage percentage of 0.3% or less when measured in conformity with JIS K7133 after heating of the resin film under a condition of 150°C for 2 hours, and a glass-transition temperature (Tg) of a resin constituting the resin film is 100°C or lower.

### [Resin film]

A resin film constituting the base material for gas-barrier films of the present invention (hereinafter, may be described simply as "a base material") is one having a thermal shrinkage percentage of 0.3% or less when measured in conformity with JIS K7133 after heating of the resin film under a condition of 150°C for 2 hours (hereinafter, may be described as "a resin film (A)").

The use of one having a thermal shrinkage percentage of 0.3% or less as the resin film makes it possible, even in a heating process to be performed when an electronic device such as an organic EL is produced, to suppress deformation of the electronic device and to suppress performance deterioration.

In a case where a base material that is unlikely to show thermal shrinkage is to be produced, in usual cases, a resin film made from a resin having a high glass-transition temperature (Tg) is selected as a production material. However, such a resin is expensive to cause a problem of production cost.

Regarding this point, the base material of the present invention uses, as a production material, a resin film containing a versatile resin having a glass-transition temperature (Tg) of 100°C or lower as a resin component.

Accordingly, the use of the base material of the present invention makes it possible to produce industrially advantageously an intended base material for gas-barrier films.

A thermal shrinkage percentage of the resin film (A) measured under above-described condition is 0.3% or less, preferably 0.01 - 0.3%, and more preferably 0.01 - 0.25%.

The fact that the thermal shrinkage percentage is 0.3% or less can give a base material having intended properties.

A resin component constituting the resin film (A) is not particularly limited so long as it has a glass-transition temperature (Tg) of 100°C or lower, and one having excellent transparency is preferable.

The glass-transition temperature (Tg) of the resin film (A) can be measured by a known measurement method, for example, with a differential scanning calorimetric measurement apparatus at temperature increase/ decrease speed of 20°C/min.

The resin component constituting the resin film (A) may be a crystalline resin or an amorphous resin, and a crystalline resin is preferable.

Crystalline resins include polyesters such as polyethylene terephthalate and polybutylene terephthalate; polyolefins such as polyethylene and polypropylene; polyamides such as polyamide 6 (nylon 6) and polyamide 66 (nylon 66); fluorocarbon resins such as polyvinylidene fluoride; polyacetal; polyphenylene sulfide; and the like.

Amorphous resins include polyvinyl chloride, polyvinylidene chloride, polystyrene, acrylonitrile-styrene resin, acrylonitrile-butadiene-styrene resin, methacrylic resin, polyvinyl acetate and the like.

These resin components can be used in one kind alone, or in two or more kinds in combination.

Among these, because of excellent transparency, and versatility, a polyester film is preferable, and polyethylene terephthalate is particularly preferable.

The resin film (A) may contain various kinds of additives in a range that does not hinder the effect of the present invention. Additives include an ultraviolet-ray absorber, an antistatic agent, a stabilizer, an oxidation inhibitor, a plasticizer, a lubricant, a coloring pigment, and the like. Each content of these additives may be appropriately determined in accordance with a purpose.

Examples of the resin film (A) include a resin film that is obtained by giving an annealing treatment to a resin film before an annealing treatment (hereinafter, may be referred to as "a resin film (B)") produced by a known method such as a melt extrusion method or a cast method.

An annealing treatment means a treatment for removing internal strain in the resin film (B) by heating the resin film (B) in a state where substantially tension is not applied.

As a consequence of giving the annealing treatment, the resin film (B) is changed to a resin film that is unlikely to show thermal shrinkage (that is, the resin film (A)). The resin film (B) may be one to which a stretching treatment has been applied.

As described above, as the resin film (A), a polyester film to which an annealing treatment has been given is preferable.

The annealing treatment can be performed according to a known method. For example, the annealing treatment can be given to the resin film (B) by a method of heating the resin film (B) in a furnace with a pre-set temperature for a predetermined time, a method of heating the resin film (B) using far-infrared rays, a method of contacting the resin film (B) to a heating roll, or the like.

A condition for the annealing treatment is not particularly limited.

In a case of a crystalline resin, the heating temperature is a temperature preferably lying in a range from not less than the glass-transition temperature to less than the melting point of the crystalline resin, and a temperature more preferably lying in a range from not less than the glass-transition temperature to not more than (melting point - 40°C) of the crystalline resin.

In a case of an amorphous resin, the heating temperature is preferably a temperature lying in a range from not less than (glass-transition temperature - 30°C) to less than the glass-transition temperature of the amorphous resin, and is more preferably a temperature lying in a range from not less than (glass-transition temperature - 20°C) to less than the glass-transition temperature of the amorphous resin.

A stage in which the annealing treatment is to be given is not particularly limited. For example, the annealing treatment may be given prior to the formation of the hard coat layer, or the annealing treatment may be given after the formation of the hard coat layer. In other words, the base material of the present invention may be one obtained by forming the hard coat layer over both faces of the resin film (A), or may be one obtained by giving the annealing treatment to a composite film obtained by forming the hard coat layer over both faces of the resin film (B) and changing the resin film (B) in the composite film to the resin film (A).

The glass-transition temperature (Tg) of the resin constituting the resin film (A) is 100°C or lower, preferably 50 - 95°C, and more preferably 60 - 90°C.

In a case where a base material that is unlikely to show thermal shrinkage is to be produced, in usual cases, a resin film made from a resin having a high glass-transition temperature (Tg) is selected as a production material. However, such a resin is usually expensive to cause a problem of production cost.

In this regard, the base material of the present invention uses, as a production material, a resin film containing a resin having a glass-transition temperature (Tg) of 100°C or less as a resin component, and, for example as described above, thermal shrinkage properties of this resin film is improved by the annealing treatment to give one that possesses intended properties.

The thickness of the resin film (A) is not particularly limited, and lies in a range of: usually 1.0 - 400 µm, preferably 5 - 300 µm, more preferably 10 - 200 µm. Thickness of a resin film is measured without any particular limitation, and can be measured mechanically, for example, with a thickness meter.

### [Hard coat layer]

The base material of the present invention has a resin film and a hard coat layer directly or via another layer over each of both faces thereof. In the present description, regarding two hard coat layers, one may be referred to as a hard coat layer (I), and the other to as a hard coat layer (II). Moreover, two hard coat layers [hard coat layer (I), hard coat layer (II)] may be referred to collectively as the hard coat layer.

The hard coat layer constituting the base material of the present invention is a layer for protecting the resin film (A) from shock and the like.

Moreover, in the base material of the present invention, the hard coat layer also plays a role of suppressing deterioration in transparency of the resin film (A) due to heating. In other words, in a case where the resin film (A) is heated, a haze value tends to increase after the heating, but in a case where the composite film having a hard coat layer over each of the both faces of the resin film (A) (the base material of the present invention) is heated, a haze value that is approximately the same as that before the heating can be obtained even after the heating.

Hard coat layers constituting the base material of the present invention include one composed of a cured material of an energy ray-curable resin. In the base material of the present invention, two hard coat layers may be formed from energy ray-curable resins having the same composition, or may be formed from energy ray-curable resins each having different composition.

The energy ray-curable resin means a curable resin composition in which a curing reaction is initiated by performing irradiation of an active energy ray such as ultraviolet ray or electron beam, or performing heating, to cause conversion to a cured product.

The energy ray-curable resin usually contains a polymerizable compound as a main component. Here, the "main component" means a component contained in 50% by mass or more as a solid content in an energy ray-curable resin.

The polymerizable compound is a compound having an energy-polymerizable functional group. Examples of energy-polymerizable functional groups include ethylenically unsaturated groups such as a (meth)acryloyl group, a vinyl group, an allyl group and a styryl group. Among these, because of high reactivity, the energy-polymerizable functional group is preferably a (meth)acryloyl group. Meanwhile, in the present description, a "(meth)acryloyl group" means an acryloyl group or a methacryloyl group.

Polymerizable compounds having a (meth)acryloyl group include polyfunctional acrylate-based compounds. Polyfunctional acrylate-based compounds mean acrylic acid ester compounds or methacrylic acid ester compounds having two or more unsaturated bonds that take part in a polymerization reaction.

Polyfunctional acrylate-based compounds include bifunctional acrylate-based compounds such as tricyclodecane dimethanol di(meth)acrylate, 1,4-butanediol di(meth)acrylate, 1,6-hexanediol di(meth)acrylate, neopentyl glycol di(meth)acrylate, polyethylene glycol di(meth)acrylate, neopentyl glycol adipate di(meth)acrylate, hydroxypivalic acid neopentyl glycol di(meth)acrylate, dicyclopentanyl di(meth)acrylate, caprolactone-modified dicyclopentenyl di(meth)acrylate, ethylene oxide-modified phosphoric acid di(meth)acrylate, di(acryloyloxyethyl)isocyanurate and allylated cyclohexyl di(meth)acrylate; trifunctional acrylate-based compounds such as trimethylolpropane tri(meth)acrylate, dipentaerythritol tri(meth)acrylate, propionic acid-modified dipentaerythritol tri(meth)acrylate, pentaerythritol tri(meth)acrylate, propylene oxide-modified trimethylolpropane tri(meth)acrylate and tris(2-acryloyloxyethyl)isocyanurate; tetrafunctional acrylate-based compounds such as diglycerin tetra(meth)acrylate and pentaerythritol tetra(meth)acrylate; pentafunctional acrylate-based compounds such as propionic acid-modified dipentaerythritol penta(meth)acrylate; hexafunctional acrylate-based compounds such as dipentaerythritol hexa(meth)acrylate and caprolactone-modified dipentaerythritol hexa(meth)acrylate; and the like.

Among these, as a polyfunctional acrylate-based compound, tetra- to hexa-functional acrylate-based compounds are preferable, and hexa-functional acrylate-based compounds are more preferable.

These polyfunctional acrylate-based compounds can be used in one kind alone, or in two or more kinds in combination.

The energy-curable resin may contain an oligomer. The oligomers include polyester acrylate-based oligomers, epoxy acrylate-based oligomers, urethane acrylate-based oligomers, polyol acrylate-based oligomers, and the like.

The energy-curable resin may contain a polymerization initiator such as a photopolymerization initiator or a thermal polymerization initiator.

Photopolymerization initiators include ketone-based photopolymerization initiators such as 2,2-dimethoxy-1,2-diphenylethan-1-one and 1-hydroxy-cyclohexyl-phenyl ketone; phosphorous-based photopolymerization initiators such as 2,4,6-trimethylbenzoyl-diphenylphosphine oxide, bis(2,4,6-trimethylbenzoyl)phenylphosphine oxide, ethyl(2,4,6-trimethylbenzoyl) phenylphosphinate and bis(2,6-dimethoxybenzoyl)-2,4,4-trimethylpentylphosphine oxide; titanocene-based photopolymerization initiators such as bis(η5-2,4-cyclopentadien-1-yl)-bis[2,6-difluoro-3-(1H-pyrrole-1-yl)-phenyl]titanium; oxime ester-based photopolymerization initiators; benzophenone-based photopolymerization initiators such as benzophenone, p-chlorobenzophenone and 4,4'-(diethylamino)benzophenone; thioxantone-based photopolymerization initiators such as thioxantone; amine-based photopolymerization initiators such as triisopropanolamine; and the like. These can be used in one kind alone, or in two or more kinds in combination.

Thermal polymerization initiators include hydrogen peroxide; peroxodisulfates such as ammonium peroxodisulfate, sodium peroxodisulfate and potassium peroxodisulfate; azo-based compounds such as 2,2'-azobis(2-amidinopropane) dihydrochloride, 4,4'-azobis(4-cyanovaleric acid), 2,2'-azobisisobutyronitrile and 2,2'-azobis(4-methoxy-2,4-dimethylvaleronitrile); organic peroxides such as benzoyl peroxide, lauroyl peroxide, peracetic acid, persuccinic acid, di-t-butyl peroxide, t-butyl hydroperoxide and cumene hydroperoxide; and the like. These can be used in one kind alone, or in two or more kinds in combination.

In a case where an energy-curable resin contains a polymerization initiator, the content thereof lies usually in a range of 0.01 to 20 parts by mass relative to 100 parts by mass of a polymerizable compound.

The energy ray-curable resin may contain a crosslinking agent.

Crosslinking agents include isocyanate-based crosslinking agents, epoxy-based crosslinking agents, melamine-based crosslinking agents, imine-based crosslinking agents, aziridine-based crosslinking agents, oxazoline-based crosslinking agent and the like.

The isocyanate-based crosslinking agent is not particularly limited and compounds having two or more isocyanate groups in a molecule are used. For example, these include aromatic polyisocyanates such as tolylene diisocyanate, diphenylmethane diisocyanate and xylylene diisocyanate; aliphatic polyisocyanates such as hexamethylene diisocyanate; alicyclic polyisocyanates such as isophorone diisocyanate and hydrogenated diphenylmethane diisocyanate; biuret bodies and isocyanurate bodies thereof and furthermore adduct bodies that are reaction products thereof with a low-molecular-weight active hydrogen-containing compound such as ethylene glycol, propylene glycol, neopentyl glycol, trimethylolpropane or castor oil; and the like.

These crosslinking agents may be used in one kind alone, or in two or more kinds in combination.

In a case where an energy-curable resin contains a crosslinking agent, the content thereof is, relative to 100 parts by mass of a polymerizable compound, usually 1 to 10 parts by mass, and preferably 2 to 8 parts by mass, from the viewpoint of obtaining a more excellent effect of the present invention.

As an energy-curable resin, one in which a polymerizable compound is a resin that is cured by ultraviolet-ray irradiation (an ultraviolet-ray-curable resin) is preferable. The use of the ultraviolet-ray-curable resin makes it possible to form effectively a hard coat layer.

The energy-curable resin may contain additionally an inorganic material.

As a consequence of containing an inorganic material, it becomes possible to further increase hardness of the hard coat layer. Moreover, it becomes possible to suppress cure shrinkage of the energy-curable resin.

Inorganic compounds constituting the inorganic material include metal oxides, alkyl silicates, metal fluorides and the like.

Metal oxides include silicon oxides such as colloidal silica and hollow silica; aluminum oxide, germanium oxide, titanium oxide, zinc oxide, zirconium oxide, tantalum oxide, indium oxide, hafnium oxide, tin oxide, niobium oxide, indium-tin oxide (ITO), antimony oxide, cerium oxide, and the like.

Alkyl silicates include alkyl silicates represented by a formula: R^{a}-O[-{Si(OR^{b})₂}-O-]ₙ-R^{a} (where R^{a} and R^{b} each represents an alkyl group having 1 - 10 carbon atoms, and n represents 1 or a larger integer).

Metal fluorides include magnesium fluoride, sodium fluoride, and the like.

Among these, as the inorganic material, silica fine particles or alkyl silicate fine particles are preferable.

As the inorganic material, those having a reactive functional group on a surface are preferable, from the viewpoint of improving hardness of the hard coat layer. High hardness can suppress precipitation of an oligomer component.

Reactive functional groups include a (meth)acryloyl group, a vinyl group, an epoxy group, a styryl group, an amino group, a ureide group, a halogen atom, a mercapto group, a sulfide group, an isocyanate group, an allyl group, a hydroxyl group, and the like. Among these, a (meth)acryloyl group is preferable from the viewpoint of high reactivity and easy availability.

Inorganic materials having a reactive functional group on a surface can be obtained, for example, by treating above-described inorganic materials with a surface-treating agent having a reactive functional group.

Surface-treating agents having the reactive functional group include silane coupling agents having a reactive functional group, titanate coupling agents having a reactive functional group, aluminate coupling agents having a reactive functional group, zirconate coupling agents having a reactive functional group, and the like.

Silane coupling agents having a reactive functional group include silane coupling agents having a (meth)acryloyl group, such as 3-methacryloxypropylmethyldimethoxysilane, 3-methacryloxypropyltrimethoxysilane, 3-methacryloxypropylmethyldiethoxysilane, 3-methacryloxypropyltriethoxysilane and 3-acryloxypropyltrimethoxysilane; silane coupling agents having a vinyl group, such as vinyltrimethoxysilane, vinyltriethoxysilane, dimethoxymethylvinylsilane, diethoxymethylvinylsilane, trichlorovinylsilane and vinyltris(2-methoxyethoxy)silane; silane coupling agents having an epoxy group, such as 2-(3,4-epoxycyclohexyl)ethyltrimethoxysilane, 3-glycidoxypropyltrimethoxysilane, 3-glycidoxypropylmethyldiethoxysilane and 3-glycidoxypropyltriethoxysilane; silane coupling agents having a styryl group, such as p-styryltrimethoxysilane and p-styryltriethoxysilane; silane coupling agents having an amino group, such as N-(2-aminoethyl)-3-aminopropy lmethyldimethoxysilane, N-(2-aminoethyl)-3-aminopropyltrimethoxysilane, N-(2-aminoethyl)-3-aminopropyltriethoxysilane, 3-aminopropyltrimethoxysilane, 3-aminopropyltriethoxysilane, 3-triethoxysilyl-N-(1,3-dimethyl-butylidene)propylamine, N-phenyl-3-aminopropyltrimethoxysilane and a hydrochloride salt of N-(vinylbenzyl)-2-aminoethyl-3-aminopropyltrimethoxysilane; silane coupling agents having a ureide group, such as 3-ureidopropyltrimethoxysilane and 3-ureidopropyltriethoxysilane; silane coupling agents having a halogen atom, such as 3-chloropropyltrimethoxysilane and 3-chloropropyltriethoxysilane; silane coupling agents having a mercapto group, such as 3-mercaptopropylmethyldimethoxysilane and 3-mercaptopropyltrimethoxysilane; silane coupling agents having a sulfide group, such as bis(trimethoxysilylpropyl)tetrasulfide and bis(triethoxysilylpropyl)tetrasulfide; silane coupling agents having an isocyanate group, such as 3-isocyanatepropyltrimethoxysilane and 3-isocyanatepropyltriethoxysilane; silane coupling agents having an allyl group, such as allyltrichlorosilane, allyltriethoxysilane and allyltrimethoxysilane; silane coupling agents having a hydroxyl group, such as 3-hydroxypropyltrimethoxysilane and 3-hydroxypropyltriethoxysilane; and the like.

Titanate coupling agents include tetrakis[2,2-bis(allyloxymethyl)butoxy]titanium (IV), di-i-propoxytitanium diisostearate, (2-n-butoxycarbonylbenzoyloxy)tributoxytitanium, triisostearic acid isopropyltitanium, di-n-butoxy-bis(triethanolaminato)titanium, tetrakis(2-ethylhexyloxy)titanium, di-i-propoxy-bis(acetylacetonato)titanium, and the like.

Aluminate coupling agents include aluminum isopropylate, aluminum ethylate, aluminum-tri-sec-butoxide, mono-sec-butoxyaluminum diisopropylate, aluminum ethylacetoacetate diisopropylate, aluminum tris(ethyl acetoacetate), aluminum tris(acetylacetonate), aluminum bisethylacetoacetate monoacetylacetonate, acetalkoxyaluminum diisopropylate, alkylacetoacetatealuminum diisopropylate, aluminum ethylacetoacetate dibutyrate, aluminum(ethylacetoacetate) monobutyrate, aluminum oxide isopropoxide trimer, aluminum oxide octylate trimer, aluminum oxide stearate trimmer, and the like.

Zirconate coupling agents include tetra-n-butoxyzirconium, tetra-t-butoxyzirconium, tetra-n-propoxyzirconium, acetylacetone tributoxyzirconium, tetraacetylacetonatezirconium, dibutoxybis(ethylacetoacetate)zirconium, octylatezirconium, tributoxystearatezirconium, monobutoxytriisostearatezirconium, and the like.

These silane coupling agents, titanate coupling agents, aluminate coupling agents and zirconate coupling agents can be used in one kind alone, or in two or more kinds in combination.

In a case where an energy ray-curable resin contains an inorganic material, the content thereof is, relative to 100 mass parts of the energy ray-curable resin, usually 50 - 200 mass parts, and preferably 80 - 140 mass parts.

As a consequence of the fact that the content of the inorganic material lies in this range, cure shrinkage of the hard coat layer can be suppressed.

A shape of the inorganic material is not particularly limited. The shape of the inorganic material maybe spherical or nonspherical. In a case where the shape is nonspherical, it may be an indeterminate form or may have a shape of a high aspect ratio such as a needle-like shape or flaky shape.

An average particle diameter of the inorganic material is usually not less than 5 nm and not more than 900 nm, preferably not less than 10 nm and not more than 500 nm, and more preferably not less than 20 nm and not more than 100 nm. A fact that the average particle diameter lies in the above-described range makes it possible to fill more densely the inorganic material into the hard coat layer.

The average particle diameter of the inorganic material can be measured by a laser diffraction/ scattering method described in JIS Z8825: 2013.

The energy ray-curable resin may contain other components in a range that does not hinder the effect of the present invention.

Other components include an antistatic agent, a stabilizer, an oxidation inhibitor, a plasticizer, a lubricant, a coloring pigment, and the like. A content of these may suitably be determined in accordance with the purpose.

As the energy-curable resins for use in the present invention, a commercial product also can be used. Commercial products include "OPSTAR Z7530", "OPSTAR Z7524", "OPSTAR TU4086" and "OPSTAR Z7537" (all are manufactured by JSR).

In the base material for gas-barrier films of the present invention (hereinafter, may be referred to as "the base material"), at least one of hard coat layers is preferably a layer of 150 nm or less in the maximum cross section height (Rt) of a roughness curve of the surface, and more preferably a layer of 100 nm or less. The lower limit of the maximum cross section height (Rt) of the roughness curve of the surface of the hard coat layer is not particularly defined, and is usually 10 nm or more.

In a case where a gas-barrier film is to be produced using the base material of the present invention, a gas-barrier film having excellent gas-barrier properties becomes easily obtainable by forming a gas-barrier layer on a hard coat layer whose maximum cross section height (Rt) of the roughness curve of surface is 150 nm or less.

The maximum cross section height (Rt) of the roughness curve of the surface of the hard coat layer can be measured by a method described in Example.

Moreover, the base material of the present invention is more preferably one in which the maximum cross section height (Rt) of the roughness curve of the surface of one hard coat layer (I) is 150 nm or less, and the maximum cross section height (Rt) of the roughness curve of the surface of the other hard coat layer (II) is not less than 150 nm and not more than 400 nm.

From the viewpoint that a gas-barrier film having more excellent gas-barrier properties can be obtained, the maximum cross section height (Rt) of the roughness curve of the surface of the hard coat layer (I) of the base material of the present invention is 150 nm or less, and preferably 100 nm or less. The lower limit value of the maximum cross section height (Rt) of the roughness curve of the surface of the hard coat layer (I) is not particularly defined, and usually 10 nm or more.

The maximum cross section height (Rt) of the roughness curve of the surface of the hard coat layer (I) can be adjusted to be 150 nm or less by adjusting the thickness of the hard coat layer (I) so that fine particles are not exposed on the surface of the hard coat layer (I).

In a case where a gas-barrier film is to be produced using the base material of the present invention, by forming a gas-barrier layer on a face of the hard coat layer (I) whose maximum cross section height (Rt) of a roughness curve of the surface is 150 nm or less, a gas-barrier film having excellent gas-barrier properties becomes easily obtainable.

Moreover, the maximum cross section height (Rt) of the roughness curve of the surface of the hard coat layer (II) is not less than 150 nm and not more than 400 nm, preferably not less than 150 nm and not more than 350 nm, and more preferably not less than 150 nm and not more than 300 nm.

Regarding the maximum cross section height (Rt) of the roughness curve of the surface of the hard coat layer (II), as will be described later, in a case where the hard coat layer (II) contains fine particles, the height (Rt) can be adjusted to be not less than 150 nm and not more than 400 nm by adjusting height of fine particles exposed on the surface thereof.

As a consequence of the fact that the maximum cross section height (Rt) of the roughness curve of the surface of the hard coat layer (II) lies in the above-described range, occurrence of problems such as blocking and air entrainment can be prevented in an operation of winding into a roll shape or feeding from a roll.

Moreover, also upon producing a gas-barrier film as will be described later, occurrence of problems such as blocking and air entrainment can be prevented in an operation of winding into a roll shape or feeding from a roll and deterioration in gas-barrier properties after this operation as compared with those before the operation can be prevented.

The hard coat layer (II) may be one that contains fine particles having an average particle diameter of not less than 1.0 um and not more than 10 µm in an energy ray-curable resin.

The use of an energy ray-curable resin containing fine particles makes it possible to adjust more easily the maximum cross section height (Rt) of the roughness curve of the surface of the hard coat layer (II) in above-described range and, as the result, occurrence of problems such as blocking and air entrainment can be prevented in an operation of winding into a roll shape or feeding from a roll. Moreover, also upon producing a gas-barrier film as will be described later, occurrence of problems such as blocking and air entrainment can be prevented in an operation of winding into a roll shape or feeding from a roll and deterioration in gas-barrier properties after this operation as compared with those before the operation can be prevented.

Both of organic fine particles and inorganic fine particles may be used as the fine particle, and organic fine particles are preferable from the viewpoint that damage to be given to the gas-barrier layer can be suppressed more.

Organic compounds constituting organic fine particles include polystyrene resin, styrene-acrylic-based copolymer resin, acrylic resin, amino resin, divinylbenzene resin, silicone resin, modified silicone resin, urethane resin, melamine resin, urea resin, phenol resin, benzoguanamine resin, xylene resin, polycarbonate resin, polyethylene resin, polyvinyl chloride resin, and the like.

Among these, silicone resin fine particles are preferable as the organic fine particle from the viewpoint of improving heat-resistance properties.

Inorganic compounds constituting inorganic fine particles include metal oxide, alkyl silicate, and the like.

Metal oxides include silicon oxides such as colloidal silica and hollow silica; titanium oxide, zinc oxide, zirconium oxide, tantalum oxide, indium oxide, hafnium oxide, tin oxide, niobium oxide, and the like.

Alkyl silicates include alkyl silicates represented by a formula: R^{c}-O[-{Si(OR^{d})₂}-O-]ₘ-R^{c} (where R^{c} and R^{d} each represents an alkyl group having 1 - 10 carbon atoms, and m represents 1 or a larger integer).

Among these, silica fine particles or alkyl silicate fine particles are preferable as the inorganic fine particle.

These fine particles may be used in one kind alone, or in two or more kinds in combination.

A shape of fine particles to be used is not particularly limited. For example, any of a spherical, needle-like, plate-like, piece-like, rod-like and fibrous shape may be acceptable. Among these, spherical one is preferable from the viewpoint that roughness can be provided stably on the surface of the hard coat layer. Here, "spherical" has a meaning of including, in addition to a true spherical shape, approximately spherical shapes including polyhedral shapes that are closely related to a spherical body such as a spheroid, an egg shape, Kompeito-like shape and a cocoon-like shape.

An average particle diameter of fine particles is usually not less than 1.0 µm and not more than 10 µm, preferably not less than 1.0 µm and not more than 8.0 µm, and more preferably not less than 1.0 µm and not more than 4.0 µm.

As will be described later, as a consequence of the use of fine particles whose average particle diameter lies in above-described range, the maximum cross section height (Rt) of the roughness curve of the surface of the hard coat layer (II) becomes easily adjustable to be not less than 150 nm and not more than 400 nm.

The average particle diameter of fine particle can be measured by a laser diffraction/ scattering described in JIS Z8825: 2013.

In a case where the hard coat layer (II) contains fine particles, content of fine particles is, relative to 100 parts by mass of the active energy ray-curable resin, usually 0.03 - 1 parts by mass, preferably 0.03 - 0.5 parts by mass, and more preferably 0.03 - 0.3 parts by mass.

As a consequence of setting the content of fine particles to lie in above-described range, a hard coat layer that has a low haze value and excellent transparency can be obtained.

A method for forming the hard coat layer is not particularly limited. For example, it can be formed by applying a coating liquid containing the energy-curable resin and a solvent directly or via another layer over the resin film (A) or (B) by a known coating method and, after drying an obtained coating film according to need, curing the coating film.

Solvents include aliphatic hydrocarbon-based solvents such as n-hexane and n-heptane; aromatic hydrocarbon-based solvents such as toluene and xylene; halogenated hydrocarbon-based solvents such as dichloromethane, ethylene chloride, chloroform, carbon tetrachloride, 1,2-dichloroethane and monochlorobenzene; alcohol-based solvents such as methanol, ethanol, propanol, butanol and propylene glycol monomethyl ether; ketone-based solvents such as acetone, methyl ethyl ketone, 2-pentanone, isophorone and cyclohexanone; ester-based solvents such as ethyl acetate and butyl acetate; cellosolve-based solvents such as ethyl cellosolve; ether-based solvents such as 1,3-dioxolan; and the like.

As a method for applying a coating liquid, usual wet coating methods can be used. For example, there are included a dipping method, roll coating, gravure coating, knife coating, air knife coating, roll knife coating, die coating, a screen printing method, spray coating, a gravure offset method, and the like.

Methods for drying a coating film include conventionally known drying methods such as hot air drying, hot roll drying and infrared ray irradiation.

A method for curing a coating film is not particularly limited. A known method can appropriately be selected in accordance with properties of an energy-curable resin.

For example, in a case where the energy-curable resin is one that is cured by receiving an active energy ray, a coating film can be cured by irradiating the coating film with the active energy ray using a high-pressure mercury lamp, an electrodeless lamp, a xenon lamp or the like.

The wavelength of the active energy ray is preferably 200 to 400 nm, and more preferably 350 to 400 nm. An irradiation dose is usually in a range of 50 to 1000 m W/cm² in illuminance, and 50 to 5000 mJ/cm² in light quantity, preferably 1000 to 5000 mJ/cm². Irradiation time is usually 0.1 to 1000 sec, preferably 1 to 500 sec, and more preferably 10 to 100 sec. In order to fulfill above-described light quantity considering a heat load in a light irradiation process, irradiation may be performed in plural times.

Moreover, in a case where an energy-curable resin is one that is cured by heating, a coating film can be cured by heating the coating film to temperatures at which a curing reaction progresses.

Each thickness of hard coat layers is preferably 1.0 - 10 µm, and more preferably 1.0 - 5.0 µm.

As a consequence of the fact that the thickness of the hard coat layer is not less than 1.0 µm, the resin film (A) can be protected sufficiently and rise in a haze value after heating the base material can be prevented sufficiently. As a consequence of the fact that the thickness of the hard coat layer is 10 µm, the base material has excellent flexibility.

The base material of the present invention may have other layers. In a case where the base material of the present invention has other layers, they include a primer layer and the like.

The primer layer includes a layer containing, as a binder resin, a resin component such as an acrylic resin, an olefin resin, a urethane resin or an ester resin.

Examples of layer constitutions of the base material of the present invention include those below, but are not limited to these. In (i) - (iii) below, the hard coat layer may be the hard coat layer (I), or may be the hard coat layer (II).
(i) hard coat layer/ resin film (A)/ hard coat layer
(ii) hard coat layer/ primer layer/ resin film (A)/ hard coat layer
(iii) hard coat layer/ primer layer/ resin film (A)/ primer layer/ hard coat layer
(iv) hard coat layer (I)/ resin film (A)/ hard coat layer (II)
(v) hard coat layer (I)/ primer layer/ resin film (A)/ hard coat layer (II)
(vi) hard coat layer (I)/ resin film (A)/ primer layer/ hard coat layer (II)
(vii) hard coat layer (I)/ primer layer/ resin film (A)/ primer layer/ hard coat layer (II)

The base material of the present invention is unlikely to show thermal shrinkage.

A thermal shrinkage percentage in the base material of the present invention after heating of 150°C for 2 hours is preferably 0.3% or less, and more preferably 0.25 - 0.01%.

The thermal shrinkage percentage can be measured by a method described in Example.

The base material of the present invention is excellent in transparency before and after heating.

Before heating, haze of the base material of the present invention is preferably 0.1 - 5.0%, and more preferably 0.1 - 1.0%.

Moreover, an amount of change in the haze after heating of 150°C for 2 hours is preferably 1.0% point or less, and more preferably 0.01 - 0.9% point.

The haze can be measured by a method described in Example, and moreover an amount of change in the haze can be calculated by a method described in Example.

The base material of the present invention may be a long-sized object. A long-sized base material is more excellent in productivity. "Long-sized" means that the shape thereof is belt-like with longer length (preferably length of 10 times or more) in a longitudinal direction as compared with length in a width direction. In explanations below, "long-sized" may be omitted. The length of the resin film (length in longitudinal direction) is not particularly limited, and is usually 400 - 2000 m. The width of the resin film (length in width direction) is not particularly limited, and is usually 450 - 1300 mm, and preferably 530 - 1280 mm. The thickness of the resin film is not particularly limited, and is usually 1.0 - 400 µm, preferably 5 - 300 µm, and more preferably 10 - 200 µm.

The base material of the present invention is used for producing a gas-barrier film.

As described above, the base material of the present invention is excellent in heat-resistance properties, and therefore the gas-barrier film obtained by using the base material of the present invention is also excellent in heat-resistance properties.

### 2) Gas-barrier film

The gas-barrier film of the present invention is one in which a gas-barrier layer is formed directly or via another layer on at least one face side of the base material for gas-barrier films of the present invention.

In particular, in a case where the gas-barrier film has a gas-barrier layer formed directly on at least one face side of the base material for gas-barrier films, preferably the gas-barrier layer is formed on a hard coat layer whose maximum cross section height (Rt) of the roughness curve of the surface is 150 nm or less. Such a gas-barrier film includes a gas-barrier layer having an approximately constant thickness, and therefore has very excellent gas-barrier properties.

### [Gas-barrier layer]

The gas-barrier layer constituting the gas-barrier film of the present invention is a layer having properties of suppressing transmission of oxygen and/or water vapor (hereinafter, referred to as "gas-barrier properties").

A water vapor transmission rate of the gas-barrier layer is, under an atmosphere of 40°C and relative humidity of 90%, preferably 5.0 g/m²/day or less, and more preferably 0.5 g/m²/day or less. As a consequence of providing a gas-barrier layer having such gas-barrier properties, gas-barrier properties of the gas-barrier film becomes more excellent. The lower limit of the water vapor transmission rate of the gas-barrier layer is not particularly limited, and is usually around 1.0×10⁻⁶ g/m²/day, considering the detection limit of a general-purpose measurement apparatus and the like.

The water vapor transmission rate can be measured, more specifically, by a method described in Example.

Meanwhile, in a case where a gas-barrier layer included in a gas-barrier film is one layer, the value of water vapor transmission rate measured for the gas-barrier film can be considered as the water vapor transmission rate of the gas-barrier layer included there.

Gas barrier layers include gas-barrier layers composed of an inorganic vapor-deposited film, gas-barrier layers containing a gas-barrier resin, gas-barrier layers obtained by modifying a surface of a layer containing a polymer compound (hereinafter, may be referred to as "a polymer layer") [in this case, the gas-barrier layer does not mean only the modified region, but means "a polymer layer including the modified region"], and the like.

Among these, because a layer that is thin and excellent in gas-barrier properties can be formed effectively, a gas-barrier layer composed of an inorganic vapor-deposited film or a gas-barrier layer obtained by modifying a surface of a polymer layer is preferable. The gas-barrier film may have two or more kinds of these gas-barrier layers.

Inorganic vapor-deposited films include vapor-deposited films of an inorganic compound or a metal.

Raw materials for a vapor-deposited film of an inorganic compound include inorganic oxides such as silicon oxide, aluminum oxide, magnesium oxide, zinc oxide, indium oxide, tin oxide, and zinc tin oxide; inorganic nitrides such as silicon nitride, aluminum nitride and titanium nitride; inorganic carbides; inorganic sulfides; inorganic oxynitrides such as silicon oxynitride; inorganic oxycarbides; inorganic nitridecarbides; inorganic oxynitride carbides and the like.

Raw materials for a vapor-deposited film of a metal include aluminum, magnesium, zinc, tin and the like.

These can be used in one kind alone, or in two or more kinds in combination.

Among these, from the viewpoint of gas-barrier properties, inorganic vapor-deposited films derived from an inorganic oxide, inorganic nitride or metal as a raw material are preferable, and in addition from the viewpoint of transparency, inorganic vapor-deposited films derived from an inorganic oxide or inorganic nitride as a raw material are preferable. The inorganic vapor-deposited film may be of a single layer or multilayers.

Thickness of the inorganic vapor-deposited film lies preferably in a range of 1 - 2000 nm, more preferably 3 - 1000 nm, further preferably 5 - 500 nm, and furthermore preferably 40 - 200 nm, from the viewpoint of gas-barrier properties and handling properties.

A method for forming the inorganic vapor-deposited film is not particularly limited, and a known method can be used. Examples of methods for forming an inorganic vapor-deposited film include PVD methods such as a vacuum deposition method, a sputtering method and an ion plating method; CVD methods such as a thermal CVD method, a plasma CVD method and a photo-CVD method; and an atomic layer deposition method (ALD method).

Examples of the gas-barrier resins include resins that are unlikely to allow transmission of oxygen, water vapor and the like, such as polyvinyl alcohol or a partially saponified product thereof, ethylene-vinyl alcohol copolymer, polyacrylonitrile, polyvinyl chloride, polyvinylidene chloride and polychlorotrifluoroethylene.

The thickness of the gas-barrier layer containing a gas-barrier resin lies in a range of preferably 1 - 2000 nm, more preferably 3 - 1000 nm, further preferably 5 - 500 nm, and furthermore preferably 40 - 200 nm, from the viewpoint of gas-barrier properties.

Methods for forming a gas-barrier layer containing a gas-barrier resin include a method in which a solution containing a gas-barrier resin is applied onto the base material or another layer and an obtained coating film is dried suitably.

Methods for applying a resin solution are not particularly limited, and include known application methods such as a spin-coating method, a spray-coating method, a bar-coating method, a knife-coating method, a roll-coating method, a blade-coating method, a die-coating method, and a gravure-coating method.

As a drying method of a coating film, a conventionally known drying method such as hot air drying, hot roll drying or infrared ray irradiation can be utilized.

Polymer compounds to be used in a gas-barrier layer constituted by modifying a surface of a polymer layer include silicon-containing polymer compounds, polyimide, polyamide, polyamide-imide, polyphenylene ether, polyether ketone, polyether ether ketone, polyolefin, polyester, polycarbonate, polysulfone, polyethersulfone, polyphenylenesulfide, polyarylate, acrylic-based resins, alicyclic hydrocarbon-based resins, aromatic polymers, and the like.

Among these polymer compounds, silicon-containing polymer compounds are preferable. Silicon-containing polymer compounds include polysilazane-based compounds, polycarbosilane-based compounds, polysilane-based compounds, polyorganosiloxane-based compounds, poly(disilanylenephenylene)-based compounds, poly(disilanyleneethynylene)-based compounds and the like, and polysilazane-based compounds are more preferable. Details of polysilazane-based compounds will be described later.

These polymer compounds can be used in one kind alone, or in two or more kinds in combination.

The polymer layer may contain other components in addition to above-described polymer compound in a range that does not inhibit the purpose of the present invention. Other components include a curing agent, an aging inhibitor, a light stabilizer, a flame retardant, and the like.

The content of the polymer compound in the polymer layer is preferably 50% by mass or more, and more preferably 70% by mass or more, because a gas-barrier layer having more excellent gas-barrier properties can be formed.

The thickness of the polymer layer is not particularly limited, and is usually 20 nm to 50 µm, preferably 30 nm to 1 µm, and more preferably 40 nm to 500 nm.

The polymer layer can be formed, for example, by applying a liquid obtained by dissolving or dispersing a polymer compound in an organic solvent onto the base material or another layer by a known coating method, and drying the obtained coating film.

Organic solvents include aromatic hydrocarbon-based solvents such as benzene and toluene; ester-based solvents such as ethyl acetate and butyl acetate; ketone-based solvents such as acetone, methyl ethyl ketone and methyl isobutyl ketone; aliphatic hydrocarbon-based solvents such as n-pentane, n-hexane and n-heptane; alicyclic hydrocarbon-based solvents such as cyclopentane and cyclohexane; and the like.

These solvents can be used in one kind alone, or in two or more kinds in combination.

Application methods include a bar-coating method, a spin-coating method, a dipping method, a roll-coating method, a gravure-coating method, a knife-coating method, an air knife-coating method, a roll knife-coating method, a die-coating method, a screen printing method, a spray-coating method, a gravure offset method, and the like.

Methods for drying a coating film include conventionally known drying methods such as hot air drying, hot roll drying and infrared ray irradiation. Heating temperature is usually 80 to 150°C, and heating time is usually several tens of seconds to several tens of minutes.

Methods for modifying a polymer layer surface include an ion injection treatment, a plasma treatment, an ultraviolet-ray irradiation treatment, a heat treatment, and the like.

The ion injection treatment is a method of injecting accelerated ions into a polymer layer to modify the polymer layer, as will be described later.

The plasma treatment is a method of exposing a polymer layer in plasma to modify the polymer layer. For example, the plasma treatment can be performed according to the method described in Japanese Patent Laid-Open No. 2012-106421.

The ultraviolet-ray irradiation treatment is a method of irradiating a polymer layer with ultraviolet-rays to modify the polymer layer. For example, an ultraviolet-ray modifying treatment can be performed according to the method described in Japanese Patent Laid-Open No. 2013-226757.

Among these gas-barrier layers, one obtained by subjecting a layer containing a silicon-containing polymer compound to an ion injection treatment is preferable, because of more excellent gas-barrier properties.

Silicon-containing polymer compounds include those similar to those exemplified above, and among those polysilazane-based compounds are preferable.

Polysilazane-based compounds are compounds having a repeating unit containing a -Si-N- bond (silazane bond) in a molecule. Specifically, compounds having a repeating unit represented by formula (1) are preferable.

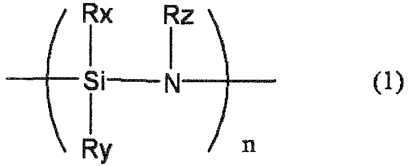

Number average molecular weight of a polysilazane-based compound to be used is not particularly limited, and is preferably 100 to 50,000.

In the formula (1), n represents an arbitrary natural number. Rx, Ry, Rz each independently represents a hydrogen atom, or a non-hydrolyzable group including an unsubstituted or substituted alkyl group such as a methyl group, ethyl group and trifluoromethyl group; an unsubstituted or substituted cycloalkyl group such as a cyclopentyl group and cyclohexyl group; an unsubstituted or substituted alkenyl group such as a vinyl group and allyl group; an unsubstituted or substituted aryl group such as a phenyl group and 4-methylphenyl group; or an alkylsilyl group such as a trimethylsilyl group.

Among these, as each of Rx, Ry and Rz, a hydrogen atom, an alkyl group having 1 to 6 carbon atoms or a phenyl group is preferable, and a hydrogen atom is particularly preferable.

Polysilazane-based compounds having a repeating unit represented by the formula (1) may be either an inorganic polysilazane in which each of Rx, Ry and Rz is a hydrogen atom, or an organic polysilazane in which at least one of Rx, Ry and Rz is not a hydrogen atom.

Moreover, in the present invention, a polysilazane-modified product may also be used as a polysilazane-based compound. Examples of polysilazane-modified products include those described in Japanese Patent Laid-Open Nos. 62-195024 and 63-81122, Japanese Patent Laid-Open Nos. 2-84437, 1-138108, 2-175726, 5-238827, 5-238827, 6-122852, 6-306329, 6-299118, 9-31333, 5-345826 and 4-63833, and the like.

Among these, from the viewpoint of easy availability and formability of an ion injection layer having excellent gas-barrier properties, perhydropolysilazane, in which each of Rx, Ry and Rz is a hydrogen atom, is preferable as the polysilazane-based compound.

Moreover, as a polysilazane-based compound, commercial products available as a glass coating material and the like can be used as is.

Polysilazane-based compounds can be used in one kind alone, or in two or more kinds in combination.

Ions to be injected in a polymer layer include ions of rare gases such as argon, helium, neon, krypton and xenon; ions of fluorocarbon, hydrogen, nitrogen, oxygen, carbon dioxide, chlorine, fluorine, sulfur and the like; ions of alkane-based gases such as methane and ethane; ions of alkene-based gases such as ethylene and propylene; ions of alkadiene-based gases such as pentadiene and butadiene; ions of alkyne-based gases such as acetylene; ions of aromatic hydrocarbon-based gases such as benzene and toluene; ions of cycloalkane-based gases such as cyclopropane; ions of cycloalkene-based gases such as cyclopentene; ions of metals; ions of organic silicon compounds; and the like.

These ions can be used in one kind alone, or in two or more kinds in combination.

Among these, ions of rare gases such as argon, helium, neon, krypton and xenon are preferable, because these ions can be injected in an easier and simpler way and can form a gas-barrier layer having more excellent gas-barrier properties.

An injection amount of ions can be suitably determined in accordance with an intended purpose (necessary gas-barrier properties, transparency, etc.) of a gas-barrier film, and the like.

Methods for injecting ions include a method of irradiation with ions accelerated by an electric field (ion beam), a method of injecting ions in plasma, and the like. Among these, the latter method of injecting ions in plasma (plasma ion injection method) is preferable because an intended gas-barrier layer can be formed in an easy and simple way.

A plasma ion injection method can be performed, for example, by generating plasma under an atmosphere containing a plasma generation gas such as a rare gas and applying a negative high voltage pulse to a polymer layer to inject ions (positive ions) in the plasma into a surface part of the polymer layer. More specifically, the plasma ion injection method can be performed by a method described in WO 2010/107018 brochure or the like.

Thickness of a region into which ions are to be injected by ion injection can be controlled by injection conditions such as a kind of the ion, applied voltage and treatment time period and may be determined in accordance with the thickness of a polymer layer, an intended purpose of a gas-barrier film and the like, and is usually 10 to 400 nm.

A fact that ions have been injected can be confirmed by performing elemental analysis measurement in a position lying around 10 nm from the surface of the polymer layer by X-ray photoelectron spectroscopy (XPS).

### [Gas-barrier film]

In a case where the gas-barrier film of the present invention has other layers, they include a primer layer and the like.

Materials constituting a primer layer include polyurethane-based resins, acrylic-based resins, polyolefin-based resins, styrene-based resins, rubber-based resins, natural resins and the like.

Average thickness of the primer layer is not particularly limited, and is preferably not less than 0.01 µm and not more than 3 µm, and more preferably not less than 0.05 µm and not more than 3 µm. As a consequence of setting the average thickness of the primer layer to be the above-described upper limit or less, blocking when a base material having the primer layer has been once wound can be suppressed.

The gas-barrier film of the present invention may be a gas-barrier film in which a gas-barrier layer is directly formed on at least one face side of hard coat layers of the base material, preferably on the face side of the hard coat layer (I), and the layer configuration thereof is not particularly limited. For example, in the base material of the present invention, a gas-barrier layer may be formed directly not only on the face side of the hard coat layer (I) but also on the face side of the hard coat layer (II). Moreover, gas-barrier layers of two or more layers may be formed directly on the face side of the hard coat layer (I) of the base material of the present invention. These two or more layers of gas-barrier layers may be the same or different each other.

Examples of layer configurations of the gas-barrier film of the present invention include following ones, but configurations thereof are not limited to these. Meanwhile, as a base material, one having a layer configuration of hard coat layer (II)/ resin film (A)/ hard coat layer (I) is exemplified in (a) - (d) below.
(a) base material/ gas-barrier layer
(b) base material/ primer layer/ gas-barrier layer
(c) gas-barrier layer/ base material/ gas-barrier layer
(d) gas-barrier layer/ primer layer/ base material/ primer layer/ gas-barrier layer
(e) gas-barrier layer/ hard coat layer (I)/ resin film (A)/ hard coat layer (II)
(f) gas-barrier layer/ hard coat layer (I)/ primer layer/ resin film (A)/ hard coat layer (II)
(g) gas-barrier layer/ hard coat layer (I)/ resin film (A)/ primer layer/ hard coat layer (II)
(h) gas-barrier layer/ hard coat layer (I)/ primer layer/ resin film (A)/ primer layer/ hard coat layer (II)
(i) gas-barrier layer/ hard coat layer (I)/ resin film (A)/ hard coat layer (II)/ gas-barrier layer/ hard coat layer (II)
(j) gas-barrier layer (II)/ gas-barrier layer (I)/ hard coat layer (I)/ resin film (A)/ hard coat layer (II)

Thickness of the gas-barrier film of the present invention is not particularly limited, and is preferably not less than 1 µm and not more than 600 µm, more preferably not less than 5 µm and not more than 400 µm, and particularly preferably not less than 20 µm and not more than 200 µm.

The thickness of the gas-barrier layer can be measured by a method described in Example.

A water vapor transmission rate of the gas-barrier film of the present invention is preferably less than 0.02 g/m²/day under an atmosphere of 40°C and 90% in relative humidity, and more preferably less than 0.01 g/m²/day. There is no lower limit value in particular, and a smaller value is more preferable, and is usually 1 × 10⁻⁶g/m²/day or more.

The water vapor transmission rate can be measured by a method described in Example.

The gas-barrier film of the present invention is one that is unlikely to show thermal shrinkage.

A thermal shrinkage percentage after heating the gas-barrier film of the present invention at 150°C for 2 hours is preferably 0.3% or less, and more preferably 0.01 - 0.25%.

A thermal shrinkage percentage can be measured by a method described in Example.

The gas-barrier film of the present invention is one that is excellent in transparency before and after heating.

Before heating, haze of the gas-barrier film of the present invention is preferably 0.1 - 5.0%, and more preferably 0.1 - 1.0%.

Moreover, an amount of change in the haze by heating at 150°C for 2 hours is preferably 1.0% point or less, and more preferably 0.01 - 0.9% points.

The haze can be measured by a method described in Example, and an amount of change in the haze can be calculated by a method described in Example.

The gas-barrier film of the present invention is excellent in gas-barrier properties, and is excellent in heat-resistance properties. Accordingly, in a case where an electronic device is produced by using, as a substrate, the gas-barrier film of the present invention and forming sequentially various functional layers over these, the gas-barrier film of the present invention can sufficiently withstand a heating treatment that is usually used.

A method for producing the gas-barrier film of the present invention is not particularly limited.

For example, the gas-barrier film of the present invention can be produced by forming a gas-barrier layer on a surface of at least one of hard coat layers of the base material for gas-barrier films.

### 3) Member for electronic devices and electronic device

The member for electronic devices of the present invention is characterized by including the gas-barrier film of the present invention. Accordingly, the member for electronic devices of the present invention has excellent gas-barrier properties and, therefore, can prevent deterioration of elements due to gases such as water vapor. Moreover, since it has high permeability of light and excellent heat-resistance properties, it is suitable as a member for displays such as touch panels, liquid crystal displays, EL displays, CRT displays, projection displays and plasma displays; a back sheet for solar cells; and the like.

The electronic device of the present invention is equipped with the member for electronic devices of the present invention. Specific examples of electronic devices include a touch panel, a liquid crystal display, an organic EL display, an inorganic EL display, a CRT display, a projection display, a plasma display, electronic paper, a solar cell, and the like.

In these electronic devices, the member for electronic devices of the present invention is used preferably as a substrate. For example, in a process for producing organic EL elements, there are a drying process after an etching process of ITO and a process under high humidity conditions and therefore the gas-barrier film of the present invention can be used preferably (Japanese Patent Laid-Open No. 2007-30387, etc.). Moreover, in liquid crystal display devices such as a reflection type liquid crystal display device having a configuration of a lower substrate, a reflection electrode, a lower alignment film, a liquid crystal layer, an upper alignment film, a transparent electrode, an upper substrate, a λ/4 plate and a polarizing plate, sequentially from the bottom, the member for electronic devices of the present invention can be used as a substrate for transparent electrode, upper substrate and the like. Furthermore, the member for electronic devices of the present invention can also be used as a sealing film for solar cell elements.

### [Example]

Hereinafter, the present invention will be explained in more detail with reference to Examples. However, the present invention is not limited to Examples below.

In each example, "part" and "%" are based on mass, unless otherwise noted.

### [Example 1]

Onto a polyester film having been subjected to an annealing treatment (manufactured by I'm corporation, 2002AF-PET100, thickness: 100 µm, thermal shrinkage percentage measured under a condition below was 0.13%) (hereinafter, referred to as "a PET film (1)"), an ultraviolet ray (UV)-curable acrylate resin composition (manufactured by JSR, OPSTAR Z7530) was applied using a wire bar, and an obtained coating film was dried at 70°C for 1 minute. Subsequently, using an electrodeless UV lamp system (manufactured by Heraeus Noblelight), ultraviolet rays were irradiated to the coating film at 250 m W/cm² in illuminance and 170 mJ/cm² in light amount to cure this, to form a hard coat layer (1) having thickness of 1.5 µm.

Subsequently, on the PET film (1) of the obtained PET film (1) with the hard coat layer (1), a hard coat layer (2) having thickness of 1.5 µm was formed in the same way as above to give a base material (1) of a layer structure of hard coat layer (1)/ PET film (1)/ hard coat layer (2). In what follows, a hard coat layer may be represented as "an HC layer."

### [Example 2]

The procedure in Example 1 was repeated, except for changing each thickness of the hard coat layers (1), (2) to 10 µm, to give a base material (2).

### [Example 3]

The procedure in Example 1 was repeated, except for changing each thickness of the hard coat layers (1), (2) to 1.0 µm, to give a base material (3).

### [Example 4]

The procedure in Example 1 was repeated, except for changing each thickness of the hard coat layers (1), (2) to 0.50 µm, to give a base material (4).

### [Example 5]

The procedure in Example 1 was repeated, except for using a polyester film not having been subjected to an annealing treatment (manufactured by Toyobo Co., Ltd., COSMOSHINE A4300, thickness: 100 µm) (hereinafter, referred to as a "PET film (2)") in place of the PET film (1), to give a composite film having a layer structure of hard coat layer (1)/ PET film (2)/ hard coat layer (2). To this composite film, an annealing treatment was given at 160°C for 24 hours, to give a base material (5).

Meanwhile, after the PET film (2) single body was subjected to an annealing treatment at 160°C for 24 hours, a thermal shrinkage percentage of the obtained film was 0.036%.

### [Comparative Example 1]

The procedure in Example 1 was repeated, except for using a polyester film not having been subjected to an annealing treatment (manufactured by Toyobo Co., Ltd., COSMOSHINE A4300, thickness 50 µm, thermal shrinkage percentage measured under a condition below was 0.64%) (hereinafter, referred to as "a PET film (3)") in place of the PET film (1), to give a base material (6) having a layer structure of hard coat layer (1)/ PET film (3)/ hard coat layer (2).

### [Comparative Example 2]

The PET film (1) was used as it was, as a base material (7).

### [Comparative Example 3]

A composite film having an hard coat layer only on one face of the PET film (1), which was a production intermediate of the base material (1) obtained in Example 1, was used as a base material (8).

### [Comparative Example 4]

The PET film (3) was used as it was, as a base material (9).

### [Comparative Example 5]

A composite film having an hard coat layer only on one face of the PET film (3), which was a production intermediate of the base material (6) obtained in Comparative Example 1, was used as a base material (10).

### [Example 6]

A coating agent containing perhydropolysilazane as a main component (manufactured by MERCK PERFORMANCE MATERIALS, AQUAMICA NL110-20, solvent: xylene, concentration: 10%) was applied onto one face of the base material (1) obtained in Example 1 so as to give thickness of 200 nm, and an obtained coating film was heated and cured at 120°C for 2 minutes, to form a polysilazane layer. Subsequently, plasma ions were injected into the polysilazane layer under a condition below, using a plasma ion-injecting apparatus to form a gas-barrier layer (hereinafter, may be represented as "a GB layer"), to give a gas-barrier film (1).

### [Condition for plasma ion injection]

Inner pressure of chamber: 0.2 Pa
Plasma-generating gas: argon
Gas flow rate: 100 sccm
RF output: 1000 W
RF frequency: 1000 Hz
RF pulse width: 50 µsec
RF delay: 25 nsec
DC voltage: -6 kV
DC frequency: 1000 Hz
DC pulse width: 5 µsec
DC delay: 50 µsec
Duty ratio: 0.5%
Treatment time: 200 sec

### [Comparative Example 6]

The procedure in Example 5 was repeated, except for using the base material (6) obtained in Comparative Example 1 in place of the base material (1), to give a gas-barrier film (2).

### [Comparative Example 7]

A gas-barrier layer was formed by a method described in Example 5 on the hard coat layer of the base material (8) described in Comparative Example 3, to give a gas-barrier film (3).

### [Comparative Example 8]

A gas-barrier layer was formed by a method described in Example 5 on the hard coat layer of the base material (10) described in Comparative Example 5, to give a gas-barrier film (4).

For base materials obtained in Examples 1 - 5 and Comparative Examples 1 - 5, and for gas-barrier films obtained in Example 6 and Comparative Examples 6 - 8, following evaluations were performed. Results are shown in Table 1.

### [Measurement of surface roughness of hard coat layer]

The maximum cross section height (Rt) of a roughness curve of the surface of a hard coat layer was measured using a light interference microscope (manufactured by Veeco, NT8000).

Meanwhile, with respect to a base material having a hard coat layer on one face, this value relates to the surface of the hard coat layer; with respect to a base material having a hard coat layer on both faces, this value relates to a surface for which a smaller value had been measured; and with respect to a gas-barrier film, this value relates to a base material surface finally constituting an interface with a gas-barrier layer.

In Table 1, a case in which the maximum cross section height (Rt) of a roughness curve was 150 nm or less is denoted by "A," and a case in which it exceeded 150 nm is denoted by "B."

### [Water vapor transmission rate]

A water vapor transmission rate of a base material or a gas-barrier film was measured using a water vapor transmission rate-measuring apparatus (Manufactured by MOCON, Inc., PERMATRAN). The measurement was performed under an atmosphere of 40°C and 90% in relative humidity, which was evaluated on the bases of following standard.
A: less than 0.02 g/m²/day
B: 0.02 g/m²/day or more

### [Measurement of thermal shrinkage percentage]

A base material or a gas-barrier film was heated under a condition of 150°C for 2 hours, and a thermal shrinkage percentage was measured in conformity with JIS K7133. The measurement was repeated four times. The average value thereof is shown in Table 1.

### [Amount of change in haze]

Haze of a base material or a gas-barrier film was measured in conformity with JIS K 7136 to give a haze value (H₀). Subsequently, after these were heated under a condition of 150°C for 2 hours, the haze was measured in the same way to give a haze value (H₁). These values were substituted for a formula: H₁-H₀ to calculate an amount of change in haze (% point).

### [Evaluation of adhesiveness]

A cross-cut test was performed in conformity with JIS K 5600-5-6 using a base material having a hard coat layer as a test piece, and adhesiveness between hard coat layer and resin film was evaluated on the basis of a standard below.
A: among 100 squares, number of taken off squares was 0
B: among 100 squares, number of taken off squares was 1 - 49
C: among 100 squares, number of taken off squares was 50 - 100

**Table 1**

| | | HC layer | | Water vapor transmission rate | Thermal shrinkage percentage (%) | Amount of change in (% haze (% point) | Adhesiveness |
|---|---|---|---|---|---|---|---|
| | | Thickness (µm) | Surface roughness | | | | |
| Example 1 | Base material (1) (HC layer/ PET film/ HC laver) | 1.5 | A | B | 0.2 | 0.5 | A |
| Example 2 | Base material (2) (HC layer/ PET film/ HC laver) | 10 | A | B | 0.2 | 0.5 | A |
| Example 3 | Base material (3) (HC layer/ PET film/ HC layer) | 1.0 | A | B | 0.2 | 0.5 | A |
| Example 4 | Base material (4) (HC layer/ PET film/ HC layer) | 0.5 | B | B | 0.2 | 0.5 | A |
| Example 5 | Base material (5) (HC layer/ PET film/ HC layer) | 1.5 | A | B | 0.1 | 0.3 | A |
| Comparative Example 1 | Base material (6) (HC layer/ PET film/ HC layer) | 1.5 | A | B | 0.6 | 0.4 | A |
| Comparative Example 2 | Base material (7) (PET film) | 1.5 | - | B | 0.1 | 18 | - |
| Comparative Example 3 | Base material (8) (HC layer/ PET film) | 1.5 | A | B | 0.2 | 9 | A |
| Comparative Example 4 | Base material (9) (PET film) | 1.5 | | B | 0.6 | 27 | |
| Comparative Example 5 | Base material (10) (HC layer/ PET film) | 1.5 | A | B | 0.6 | 14 | A |
| Example 6 | Gas-barrier film (1) (GB layer/ HC layer/ PET film/ HC layer) | 1.5 | A | A | 0.2 | 0.3 | - |
| Comparative Example 6 | Gas-barrier film (2) (GB layer/ HC layer/ PET film/ HC layer) | 1.5 | A | A | 0.6 | 0.3 | - |
| Comparative Example 7 | Gas-barrier film (3) (GB layer/ HC layer/ PET film) | 1.5 | A | A | 0.2 | 6.5 | - |
| Comparative Example 8 | Gas-barrier film (4) (GB layer/ HC layer/ PET film) | 1.5 | A | A | 0.6 | 13 | - |

From Table 1, the following is understood.

The base materials obtained in Examples 1 - 5 and the gas-barrier film obtained in Example 6 show a small thermal shrinkage percentage and an amount of change in haze is small between before and after the heating.

On the other hand, the base materials obtained in Comparative Examples 1, 4 and 5 show a large thermal shrinkage percentage.

Moreover, the base materials obtained in Comparative Examples 2 - 5 have hard coat layers not on both faces of a resin film, and therefore show a considerably large haze value after the heating.

In addition, in a case where the base materials in Comparative Examples were used, gas-barrier films having intended properties could not be obtained.

### [Example 7]

Onto a face of a polyester film having been subjected to an annealing treatment (manufactured by I'm corporation, 2002AF-PET100, thickness: 100 µm, thermal shrinkage percentage measured under a condition below was 0.13%, Tg: 80°C), an ultraviolet ray (UV)-curable acrylate resin composition (manufactured by JSR, trade name: OPSTAR Z7530) was applied using a wire bar, and an obtained coating film was dried at 70°C for 1 minute. Subsequently, using a high-pressure mercury lamp (manufactured by Heraeus Noblelight), ultraviolet rays were irradiated to the coating film at 20 m/min in line speed, 250 mW/cm² in illuminance and 170 mJ/cm² in light amount, to cure the ultraviolet ray (UV)-curable acrylate resin composition, to give the hard coat layer (I) having thickness of 1.5 µm.

Subsequently, onto the face of the PET film, on which the hard coat layer (I) was not formed, of the obtained PET film with the hard coat layer (I), an ultraviolet ray (UV)-curable acrylate resin composition, which was obtained by incorporating 0.05 parts by mass of silicone fine particles (manufactured by MOMENTIVE PERFORMANCE MATERIALS JAPAN CONSOLIDATED COMPANY, trade name: Tospearl 120, average particle diameter: 2.0 µm) was applied to 100 parts by mass (solid content) of the ultraviolet ray (UV)-curable acrylate resin composition (manufactured by JSR, trade name: OPSTAR Z7530), using a wire bar, and an obtained coating film was dried at 70°C for 1 minute. Subsequently, using a high-pressure mercury lamp (manufactured by Heraeus Noblelight), ultraviolet rays were irradiated to the coating film at 20 m/min in line speed, 250 mW/cm² in illuminance and 170 mJ/cm² in light amount, to cure the ultraviolet ray (UV)-curable acrylate resin composition, to form the hard coat layer (II) having thickness of 1.5 µm.

In this way, a base material for gas-barrier films (1) having a layer structure of hard coat layer (I)/ PET film/ hard coat layer (II) was obtained.

Onto the face of the hard coat layer (II) of the thus obtained base material for gas-barrier films (1), a coating agent containing perhydropolysilazane as a main component (manufactured by MERCK PERFORMANCE MATERIALS, trade name: NL-100) was applied so as to give thickness of 200 nm, and the obtained coating film was heated and cured at 120°C for 2 minutes to form a polysilazane layer. Subsequently, plasma ions were injected under a condition below into this polysilazane layer using a plasma ion-injecting apparatus to form a gas-barrier layer, to give a gas-barrier film (7).

### [Conditions for plasma ion injection]

Inner pressure of chamber: 0.2 Pa
Plasma-generating gas: argon
Gas flow rate: 100 sccm
RF output: 1000 W
RF frequency: 1000 Hz
RF pulse width: 50 µsec
RF delay: 25 nsec
DC voltage: -6 kV
DC frequency: 1000 Hz
DC pulse width: 5 µsec
DC delay: 50 µsec
Duty ratio: 0.5%
Treatment time: 200 sec

### [Example 8]

The procedure in Example 7 was repeated, except for changing the thickness of the hard coat layer (I) to be 3.0 µm, to give a gas-barrier film (8).

### [Example 9]

The procedure in Example 7 was repeated, except for changing the thickness of the hard coat layer (I) to be 10 µm, to give a gas-barrier film (9).

### [Example 10]

The procedure in Example 7 was repeated, except for using acrylic resin fine particles (manufactured by Sekisui Plastics Co., Ltd., trade name: XX-27LA, average particle diameter: 1.3 µm) instead of using silicone fine particles and changing the thickness of the hard coat layer (II) to be 1.0 µm, to give a gas-barrier film (10).

### [Example 11]

The procedure in Example 7 was repeated, except for using styrene resin fine particles (manufactured by Soken Chemical & Engineering Co., Ltd., trade name: SX-130H, average particle diameter: 1.3 µm) instead of using silicone fine particles and changing the thickness of the hard coat layer (II) to be 1.0 µm, to give a gas-barrier film (11).

### [Example 12]

The procedure in Example 7 was repeated, except for using silicone resin fine particles (manufactured by MOMENTIVE PERFORMANCE MATERIALS JAPAN CONSOLIDATED COMPANY, trade name: Tospearl 145, average particle diameter: 4.5 µm) instead of using silicone resin fine particles having an average particle diameter of 2.0 µm and changing the thickness of the hard coat layer (II) to be 4.0 µm, to give a gas-barrier film (12).

### [Example 13]

The procedure in Example 7 was repeated, except for using acrylic resin fine particles (manufactured by Soken Chemical & Engineering Co., Ltd., trade name: MX-1000, average particle diameter: 10 µm) instead of using silicone resin fine particles and changing the thickness of the hard coat layer (II) to be 9.5 µm, to give a gas-barrier film (13).

### [Comparative Example 9]

The procedure in Example 7 was repeated, except for changing the thickness of the hard coat layer (I) to be 0.5 µm to give a gas-barrier film (14).

### [Comparative Example 10]

The procedure in Example 7 was repeated, except for changing the thickness of the hard coat layer (II) to be 0.5 µm to give a gas-barrier film (15).

### [Comparative Example 11]

The procedure in Example 7 was repeated, except for changing the thickness of the hard coat layer (II) to be 15 µm to give a gas-barrier film (16).

For gas-barrier films (7) - (1) obtained in Examples 7 - 13 and Comparative Examples 9 - 11, following measurement and evaluation were performed. Results are shown in Table 1.

### [Evaluation of thickness]

Thickness of a hard coat layer was measured in conformity with JIS K 7130 (1999) using a thickness meter (manufactured by Nikon Corporation, trade name: MH-15).

### [Measurement of surface roughness of hard coat layer]

The maximum cross section height (Rt) of a roughness curve of a surface of a hard coat layer was measured using a light interference microscope (manufactured by Veeco Instruments Inc., NT8000).

Each maximum cross section height (Rt) of roughness curves of surfaces of the hard coat layers (I) and (II) was represented on the basis of following standard.

### [Hard coat layer (I)]

A: Rt is 150 nm or less
B: Rt is larger than 150 nm
[Hard coat layer (II)]
A: Rt is not less than 150 nm and not more than 400 nm
B: Rt is larger than 400 nm
C: Rt is less than 150 nm

### [Water vapor transmission rate]

Measurement was performed under an atmosphere of 40°C and 90% in relative humidity for a sample obtained by winding once a gas-barrier film directly after production into a roll shape and then being fed, using a water vapor transmission rate-measuring apparatus (manufactured by MOCON, Inc., trade name: PERMATRAN, measurement lower limit value: 0.02 g/m²/day).

### [Measurement of thermal shrinkage percentage]

A gas-barrier film was heated under a condition of 150°C for 2 hours, and a thermal shrinkage percentage was measured in conformity with JIS K7133. The measurement was repeated four times. An average value thereof is shown in Table 1.

### [Haze and amount of change in haze]

The haze (H₀) of a gas-barrier film was measured in conformity with JIS K 7136 using a haze meter (manufactured by NIPPON DENSHOKU INDUSTRIES CO., LTD., trade name: N-DH-2000). Subsequently, this gas-barrier film was heated under a condition of 150°C for two hours, and after that the haze (H₁) was measured in the same way.

An amount of change in haze (% point) was calculated from a formula: H₁ - Ho.

### [Evaluation of curling]

A gas-barrier film was cut out into a 10 cm square to give a test piece. The test piece was placed on a horizontal glass plate so that the upper side became concave, then lift height at four corners was measured with a ruler, an average value (mm) thereof was calculated, and curling was evaluated on the basis of the standard below.
good: less than 10 mm
fair: not less than 10 mm to less than 15 mm
poor: 15 mm or more

### (Windability: presence or absence of generation of blocking or wrinkle)

Presence or absence of generation of blocking or wrinkle when a gas-barrier film was wound into a roll shape was confirmed, and windability was evaluated on the basis of the standard below. In a case of winding the film into a roll shape, a core of an ABS (acrylic-butadiene-styrene) resin having an outer diameter of 3 inches was used to wind 300 m.
good: less than 10 mm
poor: 15 mm or more

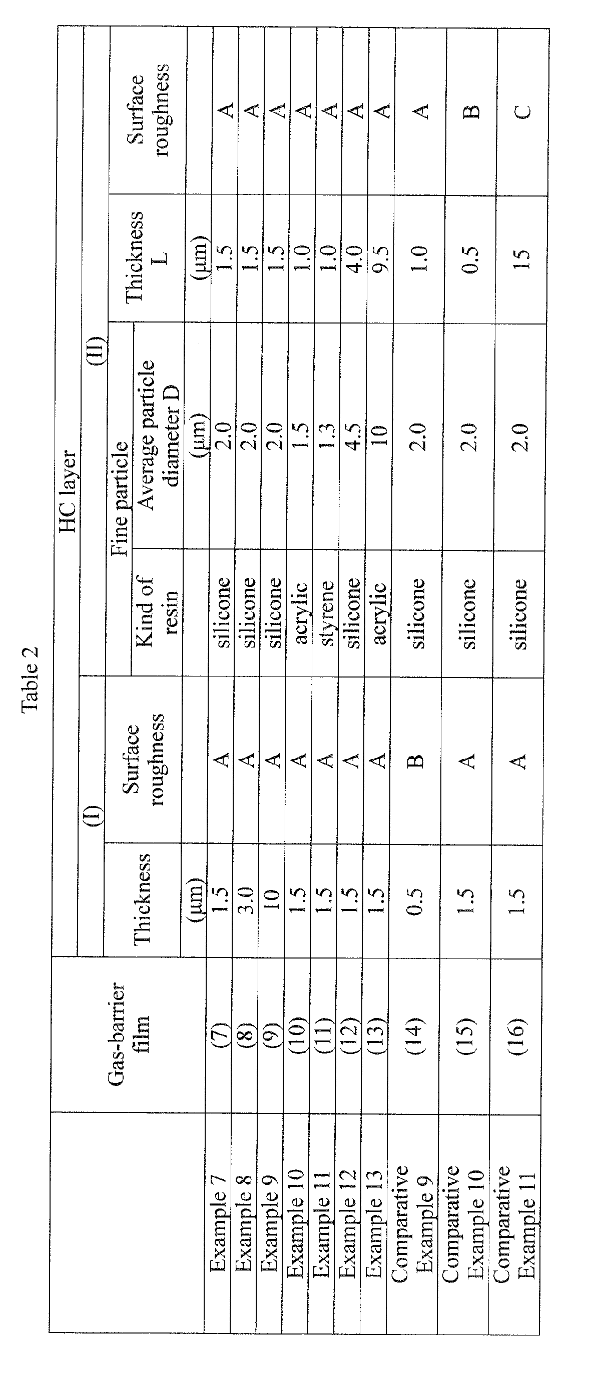

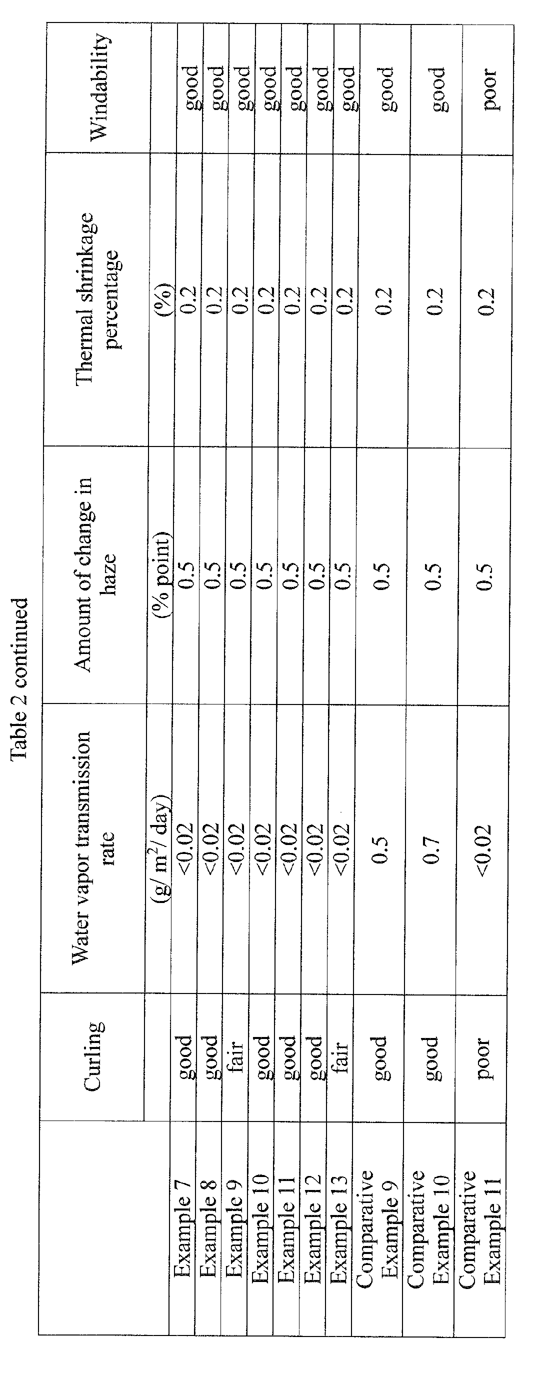

From Table 2, the following is understood.

The gas-barrier film (7) has a suitable maximum cross section height (Rt) (A rank) in each of the roughness curves of surfaces of the hard coat layers (I) and (II), and is excellent in gas-barrier properties, thermal shrinkage properties and transparency (the thermal shrinkage percentage is small, and the amount of change in haze is small between before and after heating), and is excellent also in windability (Example 7).

Moreover, also in the case of the gas-barrier films (8) and (9) obtained by setting the thickness of the hard coat layer (I) to be larger as compared with Example 7, the maximum cross section height (Rt) is suitable (A rank) in each of the roughness curves of surfaces of the hard coat layers (I) and (II), and is excellent in gas-barrier properties, thermal shrinkage properties and transparency (the thermal shrinkage percentage is small, and the amount of change in haze is small between before and after heating), and is excellent also in windability (Examples 8 and 9).

On the other hand, the gas-barrier film (14) obtained by setting the thickness of the hard coat layer (I) to be thinner has a rough maximum cross section height (Rt) (B rank) in the roughness curves of surface of the hard coat layer (I) and smoothness of the gas-barrier layer-forming face has degraded, and therefore gas-barrier properties have degraded (Comparative Example 9).

Also in the cases of gas-barrier films (10) - (13) obtained by changing the kind and particle diameter of resin fine particles and the thickness of the hard coat layer (II) relative to Example 7, the maximum cross section height (Rt) is suitable (A rank) in each of the roughness curves of surfaces of the hard coat layers (I) and (II), and is excellent in gas-barrier properties, thermal shrinkage properties and transparency (the thermal shrinkage percentage is small, and the amount of change in haze is small between before and after heating), and is excellent also in windability (Examples 10 - 13).

On the other hand, the gas-barrier film (15) obtained by setting the thickness of the hard coat layer (II) to be thinner has a rough maximum cross section height (Rt) (B rank) in the roughness curves of surface of the hard coat layer (II) and, in winding, the face of the hard coat layer (II) has damaged the face of the gas-barrier layer contacting the hard coat layer (II) to degrade gas-barrier properties (Comparative Example 10).

Moreover, the gas-barrier film (16) obtained by setting the thickness of the hard coat layer (II) to be thicker had a maximum cross section height (Rt) that was less than 150 nm (C rank) in the roughness curves of surface of the hard coat layer (II) to cause tightening (windability was degraded). In addition, cure shrinkage of the hard coat layer (II) was large and the curling amount was large to deteriorate handling ability (Comparative Example 11).

## Claims

1. A base material for gas-barrier films comprising a resin film and a hard coat layer directly or via another layer over each of both faces of the resin film, wherein:
the resin film is one that has a thermal shrinkage percentage of 0.3% or less, when measured after heating the resin film under a condition of 150°C for 2 hours in conformity with JIS K7133; and
glass-transition temperature (Tg) of a resin constituting the resin film is 100°C or lower.

2. The base material for gas-barrier films according to claim 1, wherein the resin film is a polyester film having been subjected to an annealing treatment.

3. The base material for gas-barrier films according to claim 1 or 2, wherein each of the hard coat layers is one obtained by curing an energy-curable resin.

4. The base material for gas-barrier films according to any of claims 1 to 3, wherein each thickness of the hard coat layers is 1.0 - 10 µm.

5. The base material for gas-barrier films according to any of claims 1 to 4, wherein at least one of the hard coat layers is a layer whose maximum cross section height (Rt) of a roughness curve of a surface is 150 nm or less.

6. The base material for gas-barrier films according to any of claims 1 to 5, wherein the maximum cross section height (Rt) of a roughness curve of a surface of one hard coat layer (I) is 150 nm or less, and the maximum cross section height (Rt) of a roughness curve of a surface of the other hard coat layer (II) is not less than 150 nm and not more than 400 nm.

7. The base material for gas-barrier films according to any of claims 1 to 6, which is a long-sized base material.

8. The base material for gas-barrier films according to claim 6 or 7, wherein the hard coat layer (II) contains fine particles whose average particle diameter is not less than 1.0 µm and not more than 10 µm.

9. The base material for gas-barrier films according to claim 8, wherein the fine particle is at least one kind of organic fine particle selected from the group consisting of silicone resin fine particles, acrylic resin fine particles, polystyrene resin fine particles, and styrene-acrylic copolymer resin fine particles.

10. The base material for gas-barrier films according to claim 8 or 9, wherein thickness L of the hard coat layer (II) satisfies 1.0 µm ≤ L < 10 µm and L < D, when an average particle diameter of the fine particle is denoted by D µm (when two or more kinds of fine particles are contained, it means an average particle diameter of a fine particle whose average particle diameter is the largest).

11. The base material for gas-barrier films according to any of claims 1 to 10, wherein haze is 2.0% or less.

12. A gas-barrier film comprising, directly or via another layer, a gas-barrier layer on at least one face side of the base material for gas-barrier films according to any of claims 1 to 11.

13. A gas-barrier film comprising directly a gas-barrier layer on at least one face side of the base material for gas-barrier films according to any of claims 1 to 11, wherein a hard coat layer contacting the gas-barrier layer is a layer whose maximum cross section height (Rt) of a roughness curve of a surface is 150 nm or less.

14. The gas-barrier film according to claim 12 or 13, constituted of a gas-barrier layer that is formed directly on at least the hard coat layer (I) face side of the base material for gas-barrier films according to any of claims 1 to 11.

15. The gas-barrier film according to any of claims 12 to 14, wherein the gas-barrier layer is formed by using a material containing a polysilazane-based compound.
